**Europäisches Patentamt**

**European Patent Office**

**Office européen des brevets**

(19)

(11) Numéro de publication: **0 203 012 B1**

(12) # FASCICULE DE BREVET EUROPEEN

(45) Date de publication du fascicule du brevet:
27.09.89

(51) Int. Cl.⁴: **H01L 31/02**

(21) Numéro de dépôt: **86401094.7**

(22) Date de dépôt: **23.05.86**

---

(54) **Dispositif semi-conducteur photosensible, et procédé de fabrication d'un tel dispositif.**

---

(30) Priorité: **24.05.85 FR 8507901**

(43) Date de publication de la demande:
**26.11.86 Bulletin 86/48**

(45) Mention de la délivrance du brevet:
**27.09.89 Bulletin 89/39**

(84) Etats contractants désignés:
**DE GB NL**

(56) Documents cités:
**EP-A- 0 130 847**
**DE-A- 3 033 457**
**GB-A- 2 108 755**
**US-A- 4 189 826**
**US-A- 4 428 110**

**JOURNAL OF ELECTRONIC ENGINEERING,**
**vol. 16, no. 149, mai 1979, page 24, Tokyo, JP; "Sanyo's new solar cells reduce costs per Watt"**

(73) Titulaire: **THOMSON-CSF, 51, Esplanade du Général de Gaulle, F-92800 Puteaux(FR)**

(72) Inventeur: **Blanchard, Pierre, THOMSON-CSF SCPI 19, avenue de Messine, F-75008 Paris(FR)**
Inventeur: **Cortot, Jean-Paul, THOMSON-CSF SCPI 19, avenue de Messine, F-75008 Paris(FR)**

(74) Mandataire: **Mayeux, Michèle et al, THOMSON-CSF SCPI, F-92045 PARIS LA DEFENSE CEDEX 67(FR)**

---

## Description

La présente invention concerne un dispositif semi-conducteur photosensible. Elle concerne également un procédé de fabrication d'un tel dispositif.

Il est connu de réaliser des dispositifs semi-conducteur photosensibles en utilisant des grilles en silicium, en particulier en silicium polycristallin. Ces grilles donnent entièrement satisfaction si l'on considère leurs caractéristiques MOS ou leur transparence, au rayonnement visible en particulier. Par contre, ces grilles présentent l'inconvénient d'avoir une résistivité relativement élevée, de l'ordre de 800 $\mu.\Omega.cm$. Cette résistivité ne permet pas de réaliser des dispositifs à forte intégration, c'est-à-dire avec des grilles de très faibles dimensions, fonctionnant à des fréquences élevées.

Pour obtenir des grilles de faible résitivité, il faut utiliser du siliciure ou des métaux comme l'aluminium. De telles grilles ne sont donc pas transparentes.

La présente invention se propose de résoudre le problème de la réalisation de dispositifs semi-conducteur photosensibles, munis par conséquent de grilles transparentes au rayonnement à analyser, et présentant une très faible résistivité qui permet une très grande intégration.

La présente invention concerne un dispositif semi-conducteur photosensible comportant des grilles transparentes au rayonnement à analyser, caractérisé en ce que les parois latérales de ces grilles sont en siliciure, et hormis leurs parois latérales, ces grilles sont constituées de silicium.

La présente invention concerne également un procédé de fabrication d'un dispositif, caractérisé en ce qu'il comporte les étapes suivantes :

- 1) on dépose sur le substrat semi-conducteur, une couche de diélectrique, une couche de silicium puis une couche de diélectrique ;
- 2) on décape par photolithogravure la couche de silicium recouverte de la couche de diélectrique à l'exception des zones prévues pour former les grilles;
- 3) on dépose une couche métallique pouvant donner un siliciure par alliage thermique avec du silicium ;
- 4) on réalise par traitement thermique la transformation de la couche métallique et d'une faible épaisseur de la couche de silicium avec lequel elle se trouve en contact en siliciure ;
- 5) on retire la couche métallique qui n'a pas été transformée en siliciure.

D'autres objets, caractéristiques et résultats de l'invention ressortiront de la description suivante, donnée à titre d'exemple non limitatif et illustrée par les figures annexées qui représentent :

- les figures 1 à 4, les étapes d'un procédé de fabrication d'un mode de réalisation d'un dispositif selon l'invention à un seul niveau de grilles ;
- la figure 5, un mode de réalisation d'un dispositif selon l'invention à deux niveaux de grilles.

Sur les différentes figures, les mêmes repères désignent les mêmes éléments, mais, pour des raisons de clarté, les cotes et proportions des divers éléments ne sont pas respectées.

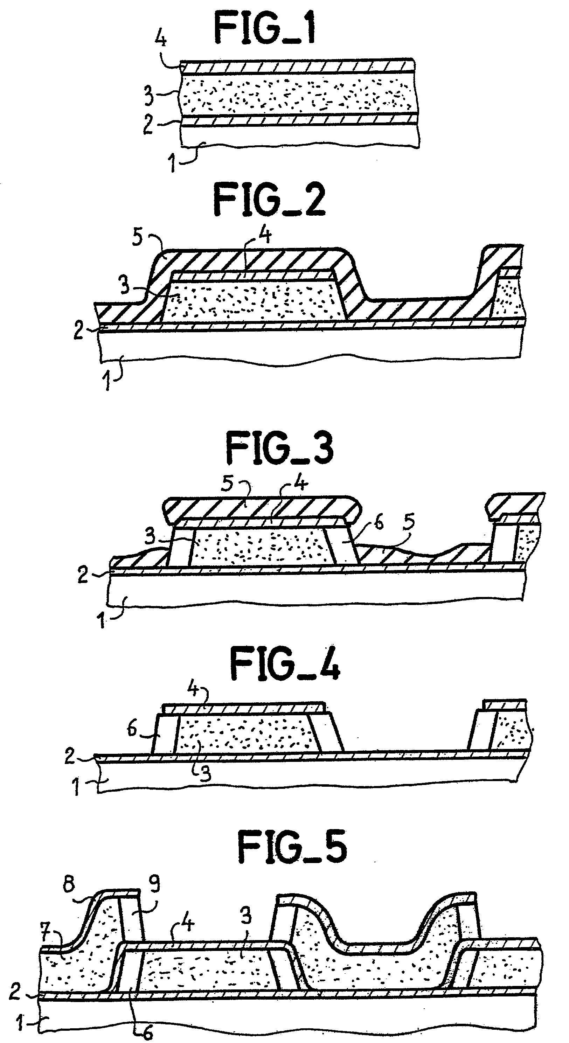

Sur les figure 1 à 4, on a représenté schématiquement diverses étapes d'un procédé de fabrication d'un mode de réalisation d'un dispositif selon l'invention à un seul niveau de grilles.

La figure 1 montre qu'on utilise un substrat semi-conducteur 1. Ce substrat peut être du silicium mono-cristallin. Il peut aussi s'agir de la couche de silicium d'une structure SOS, ou de tout autre semiconducteur.

On dépose sur ce substrat semi-conducteur une couche 2 de diélectrique. Ce diélectrique peut, par exemple, être constitué par une couche d'oxyde, une couche de nitrure, ou par la superposition d'une couche d'oxyde et d'une couche de nitrure.

Sur la couche de diélectrique, on dépose une couche 3 de silicium destiné à la réalisation des grilles.

On peut utiliser du silicium micro-cristallin ou du silicium amorphe par exemple. On utilise cependant de préférence, du silicium polycristallin car on en a une bonne maîtrise technologique.

On recouvre cette couche de silicium 3 par une couche de diélectrique 4. Il peut s'agir d'une couche d'oxyde, obtenue par croissance d'oxyde ou par dépôt, pyrolitique par exemple. Il peut aussi s'agir d'une couche de nitrure.

La figure 2 illustre l'étape suivante du procédé pendant laquelle on grave par photo-lithogravure la couche de silicium 3 recouverte de la couche de diélectrique 4. On dépose ensuite à la surface du dispositif une couche métallique 5 susceptible de donner un siliciure par alliage thermique avec le silicium.

Cette couche métallique peut être par exemple du tantale, du titane ou du tungstène.

La figure 3 représente le résultat obtenu après formation des zones en siliciure 6.

Le siliciure 6 ne se forme que dans les endroits où la couche métallique 5 est en contact direct avec le silicium polycristallin 3, c'est-à-dire uniquement sur les flancs des grilles. La partie supérieure des grilles conserve les deux couches de diélectrique 4 et de métal 5 superposées, sans qu'il y ait alliage.

Le traitement thermique qui permet la transformation de la couche métallique 5 et d'une faible épaisseur de la couche de silicium 3 avec lequel elle se trouve en contact en siliciure peut être, par exemple, réalisé en utilisant un four, à une température de 900 à 1000°C et sous atmosphère d'Argon.

On voit sur la figure 3 que, sur les parois latérales des grilles, la transformation en siliciure de la couche métallique 5 se fait en diminuant légèrement l'épaisseur de la couche de silicium polycris- tallin 3.

L'étape suivante du procédé qui est représentée sur la figure 4 consiste à retirer la couche métallique 5 qui n'a pas été transformée en siliciure.

Cela peut se faire chimiquement ou par gravure plasma.

Le dispositif qui est finalement obtenu et qui est représenté su la figure 4 comporte donc des grilles transparentes au rayonnement dont les parois latérales sont en siliciure 6 et qui, hormis ces parois latérales, sont constituées de silicium 3.

Les parois latérales en siliciure permettent une diminution importante de la résistivité de la grille par rapport à une grille entièrement en silicium. Ainsi, dans un exemple de réalisation la résistivité est diminuée par 7 de par l'utilisation de parois latérales en siliciure.

Ces parois latérales en siliciure ne masquent qu'une faible partie de la zone photosensible du dispositif tout en diminuant fortement sa résistivité.

Hormis leurs parois latérales, les grilles sont en silicium et conservent donc les caractéristiques MOS usuelles des grilles en silicium.

Il est bien entendu que le dispositif de la figure 4 peut être obtenu par un procédé différent de celui qui a été décrit.

Il faut signaler un avantage du procédé décrit qui est de pouvoir être appliqué quel que soit le relief du substrat semiconducteur 1 utilisé, et en particulier qu'il soit planarisé ou non.

Le procédé décrit peut bien sûr s'appliquer lorsque plusieurs niveaux de grilles sont utilisés. Sur la figure 5, à titre d'exemple, on a représenté le dispositif obtenu après utilisation de ce procédé lorsque deux niveaux de grilles sont utilisés avec dissymétrie par implantation d'ions.

On applique le procédé représenté sur les figures 1 à 4, ensuite on dépose une couche de silicium 7 de façon à réaliser les grilles du second niveau. On applique ensuite le procédé aux grilles du second niveau, avec dépôt d'une couche de diélectrique 8, puis d'une couche métallique qui est transformée en siliciure 9 sur les parois latérales des grilles du second niveau et qui est retirée par ailleurs. On constate sur la figure 5 que les zones en silicium opaques à la lumière sont disposées sensiblement à la verticale les unes des autres.

Une variante du dispositif selon l'invention consiste à utiliser une couche de diélectrique 4 dont l'indice optique est choisi de façon à ce qu'elle serve de couche anti-reflet.

## Revendications

1. Dispositif semi-conducteur photosensible comportant des grilles transparentes au rayonnement à analyser, caractérisé en ce que les parois latérales de ces grilles sont en siliciure (6), et hormis leurs parois latérales, ces grilles sont constitués de silicium (3).

2. Dispositif selon la revendication 1, caractérisé en ce que, hormis leurs parois latérales, les grilles sont réalisées en silicium polycristallin (3), en silicium micro-cristallin ou en silicium amorphe.

3. Dispositif selon l'une des revendications 1 ou 2, caractérisé en ce que le substrat semi-conducteur (1) sur lequel est réalisé ce dispositif est du silicium mono-cristallin ou la couche de silicium d'une structure SOS.

4. Dispositif selon l'une des revendications 1 à 3, caractérisé en ce que le substrat semi-conducteur (1) est recouvert d'une couche de diélectrique (2) constituée par une couche d'oxyde, une couche de nitrure, ou par la superposition d'une couche d'oxyde et d'une couche de nitrure.

5. Dispositif selon l'une des revendications 1 à 4, caractérisé en ce que la partie des grilles en silicium (3) est recouverte d'une couche de diélectrique (4), constituée par une couche d'oxyde ou par une couche de nitrure.

6. Dispositif selon l'une des revendications 1 à 5, caractérisé en ce que, hormis leurs parois latérales, les grilles sont constituées de silicium (3), recouvert d'une couche de diélectrique (4,8) dont l'indice optique est choisi de faon qu'elle serve de couche anti- reflet.

7. Dispositif selon l'une des revendications 1 à 6, caractérisé en ce qu'il comporte plusieurs niveaux de grilles.

8. Procédé de fabrication d'un dispositif semi-conducteur photosensible comportant des grilles transparentes au rayonnement à analyser selon l'une des reven- dications 1 à 7, caractérisé en ce qu'il comporte les étapes suivantes :

a) on dépose sur le substrat semi-conducteur (1), une couche de diélectrique(2), une couche de silicium(3) puis une couche de diélectrique(4);

b) on décape par photolithogravure la couche de silicium (3) recouverte de la couche de diélectrique (4) à l'exception des zones prévues pour former les grilles;

c) on dépose une couche métallique (5) pouvant donner un siliciure par alliage thermique avec du silicium ;

d) on réalise par traitement thermique la transformation en siliciure de la couche métallique (5) et d'une faible épaisseur de la couche de silicium (3) avec lequel elle se trouve en contact;

e) on retire la couche métallique (5) qui n'a pas été trans- formée en siliciure.

9. Procédé selon la revendication 8, caractérisé en ce que le retrait de la couche métallique (5) est réalisé par gravure chimique ou par attaque plasma.

10. Procédé selon l'une des revendications 8 ou 9, caractérisé en ce que, après l'étape e,

f) on dépose sur le substrat semi-conducteur (1) recouvert de la couche de diélectrique (2) une autre couche de silicium (7) que l'on recouvre d'une couche de diélectrique (8) ;

g) on applique ensuite les étapes b à e du procédé à cette dernière couche de silicium (7) recouverte de diélectrique (8).

## Patentansprüche

1. Lichtempfindliche Halbleitervorrichtung mit Gittern, die für eine zu untersuchende Strahlung durchlässig sind, dadurch gekennzeichnet, daß die Seitenwände dieser Gitter aus Silizid (6) und die Gitter, mit Ausnahme ihrer Seitenwände, aus Silizium (3) bestehen.

2. Vorrichtung nach Anspruch 1, dadurch gekennzeichnet, daß die Gitter, mit Ausnahme ihrer Seitenwände, aus polykristallinem Silizium (3), aus mikrokristallinem Silizium oder aus amorphem Silizium bestehen.

3. Vorrichtung nach einem der Ansprüche 1 oder 2, dadurch gekennzeichnet, daß das Halbleitersubstrat (1), auf dem diese Vorrichtung verwirklicht wird, aus monokristallinem Silizium besteht oder die Siliziumschicht einer SOS-Struktur ist.

4. Vorrichtung nach einem der Ansprüche 1 bis 3, dadurch gekennzeichnet, daß das Halbleitersubstrat (1) mit einer dielektrischen Schicht (2) bedeckt ist, die aus einer Oxidschicht, einer Nitridschicht oder aus der Überlagerung einer Oxid- und einer Nitridschicht besteht.

5. Vorrichtung nach einem der Ansprüche 1 bis 4, dadurch gekennzeichnet, daß der Gitterbereich aus Silizium (3) mit einer dielektrischen Schicht (4) bedeckt ist, die aus einer Oxidschicht oder aus einer Nitridschicht besteht.

6. Vorrichtung nach einem der Ansprüche 1 bis 5, dadurch gekennzeichnet, daß die Gitter, mit Ausnahme ihrer Seitenwände, aus Silizium (3) bestehen, das mit einer dielektrischen Schicht (4, 8) bedeckt ist, deren optischer Index so gewählt ist, daß die Schicht als Antireflexionsschicht dient.

7. Vorrichtung nach einem der Ansprüche 1 bis 4, dadurch gekennzeichnet, daß sie mehrere Gitterniveaus aufweist.

8. Verfahren zur Herstellung einer lichtempfindlichen Halbleitervorrichtung mit für das zu untersuchende Licht durchlässigen Gittern, nach einem der Ansprüche 1 bis 7, dadurch gekennzeichnet, daß es folgende Stufen aufweist:
a) Aufbringen einer dielektrischen Schicht (2), einer Siliziumschicht (3) und dann einer dielektrischen Schicht (4) auf das Halbleitersubstrat (1),
b) photolithographisches Abätzen der von der dielektrischen Schicht (4) bedeckten Siliziumschicht (3), mit Ausnahme der für die Bildung der Gitter bestimmten Zonen,
c) Aufbringen einer Metallschicht (5), die durch thermisches Legieren mit Silizium ein Silizid erzeugt,
d) Herbeiführen der Umwandlung der Metallschicht (5) und einer dünnen Schicht der mit ihr in Berührung stehenden Siliziumschicht (3) in das Silizid,
e) Entfernen der Metallschicht (5), die nicht in Silizid umgewandelt wurde.

9. Verfahren nach Anspruch 8, dadurch gekennzeichnet, daß das Entfernen der Metallschicht durch chemisches Ätzen oder Plasmaangriff erfolgt.

10. Verfahren nach einem der Ansprüche 8 oder 9, dadurch gekennzeichnet, daß nach der Stufe e)
f) eine weitere Siliziumschicht (7) auf das mit der dielektrischen Schicht (2) bedeckte Halbleitersubstrat (1) aufgebracht wird und die weitere Schicht mit einer dielektrischen Schicht (8) bedeckt wird,
g) die Stufen b) bis e) des Verfahrens auf diese letztgenannte mit dem Dielektrikum (8) bedeckte Siliziumschicht (7) angewandt wird.

**Claims**

1. A photosensitive semiconductor device comprising grids which are transparent to the radiation to be analyzed, characterized in that the side walls of these grids are made of silicide (6) and the grids are made of silicon (3), with the exception of their side walls.

2. A device according to claim 1, characterized in that the grids, with the exception of their side walls, are made of polycristalline silicon (3), or else microcrystalline silicon or else amorphous silicon.

3. A device according to any one of claims 1 to 2, characterized in that the semiconductor substrate (1), upon which this device is realized, is made of monocrystalline silicon or is the silicon layer of an SOS-structure.

4. A device according to any one of claims 1 to 3, characterized in that the semiconductor substrate (1) is covered by a dielectric layer (2) constituted of an oxide layer or else a nitride layer or else the superposition of an oxide layer and a nitride layer.

5. A device according to one of claims 1 to 4, characterized in that the grid portion made of silicon (3) is covered by a dielectric layer (4) constituted by an oxide layer or by a nitride layer.

6. A device according to one of claims 1 to 5, characterized in that the grids, with the exception of their side walls, are constituted of silicon (3), covered by a dielectric layer (4, 8) whose optical index is chosen such that the layer serves as an anti-reflection layer.

7. A device according to one of claims 1 to 6, characterized in that it is provided with a plurality of grid levels.

8. A method for the manufacture of a photosensitive semiconductor device comprising grids, which are transparent to the radiation to be analyzed, according to one of the claims 1 to 7, characterized in that it comprises the following steps:
a) depositing a dielectric layer (2), a silicon layer (3) and then a dielectric layer (4) on the semiconductor substrate (1),
b) photolithographic etching the silicon layer (3) covered by the dielectric layer (4), with the exception of the areas provided for the formation of the grids,
c) depositing a metal layer (5) capable of yielding a silicide by way of thermal alloying with silicon,
d) realizing by thermal treatment the transformation of the metal layer (5) and of a small thickness of the silicon layer (3), with which it is in contact, into the silicide,
e) removing the metal layer (5), which has not been transformed.

9. A method according to claim 8, characterized in that the removal of the metal layer (5) is effected by chemical etching or else by plasma attack.

10. A method according to one of claims 8 or 9, characterized in that further to step e), the following steps are carried out:
f) depositing another silicon layer (7) on the semiconductor substrate (1) covered by the dielectric layer (2), and covering said silicon layer with a dielectric layer (8),
g) applying thereafter the steps b) to e) of the method of manufacture to said last silicon layer (7) covered by the dielectric (8).

# FIG_1

# FIG_2

# FIG_3

# FIG_4

# FIG_5